# EUROPÄISCHE PATENTSCHRIFT

(11) **EP 0 732 727 B1**
(45) Veröffentlichungstag und Bekanntmachung des Hinweises auf die Patenterteilung: **20.03.2002**
(21) Anmeldenummer: 95115760.1
(22) Anmeldetag: 06.10.1995
(51) Int. Cl.: H01J 37/32, B08B 7/00, C23C 14/02, B08B 6/00, B01J 19/12

(54) **Vorrichtung und Verfahren zur Behandlung von Substraten mittels einer Barriereentladungsvorrichtung, die Plasmateilchen und/oder UV-Strahlung erzeugt**
Apparatus and method for treatment of substrates by means of a barrier discharge device producing plasma particles and/or UV-radiation
Appareil et méthode pour le traitement de surfaces avec un dispositif à décharge à barrière diélectrique en générant des particules de plasma et/ou des rayons UV

(30) Priorität: 04.02.1995 DE 19503718
(43) Veröffentlichungstag der Anmeldung: 18.09.1996
(73) Patentinhaber: Unaxis Deutschland Holding GmbH, 63450 Hanau (DE); FRAUNHOFER-GESELLSCHAFT ZUR FÖRDERUNG DER ANGEWANDTEN FORSCHUNG E.V., 80636 München (DE)
(72) Erfinder: Patz, Ulrich, Dr., D-63589 Linsengericht (DE); Neff, Willi, Dr., B-4721 Kelmis (BE); Scherer, Michael, Dr., D-63517 Rodenbach (DE); Pochner, Klaus, D-82072 Aachen (DE)
(74) Vertreter: Schlagwein, Udo, Dipl.-Ing.

(56) Entgegenhaltungen:
- EP-A- 0 254 111
- EP-A- 0 510 503
- EP-A- 0 560 526
- EP-A- 0 607 960
- EP-A- 0 661 110
- DE-A- 4 332 866
- DE-C- 4 125 365
- US-A- 5 269 881
- US-A- 5 427 747
- PATENT ABSTRACTS OF JAPAN vol. 018, no. 599 (E-1631), 15. November 1994 & JP 06 232056 A (USHIO INC), 19. August 1994
- PATENT ABSTRACTS OF JAPAN vol. 095, no. 002, 31. März 1995 & JP 06 312130 A (USHIO INC), 8. November 1994
- PATENT ABSTRACTS OF JAPAN vol. 095, no. 002, 31. März 1995 & JP 06 312131 A (USHIO INC), 8. November 1994
- VOLKOVA G A, KIRILLOVA N N, PAVLOVSKAYA E N, YAKOVLEVA A V: "Vacuum-ultraviolet lamps with a barrier discharge in inert gases" ZHURNAL PRIKLADNOI SPEKTROSKOPII; TRA:JOURNAL OF APPLIED SPECTROSCOPY, Bd. 41, Nr. 4, Oktober 1984, Seiten 691(1194)-695(1197), XP002082372 Byelorussian SSR / Tra: USA

## Beschreibung

Die Erfindung betrifft ein Verfahren zur Behandlung, insbesondere zur Reinigung, von Oberflächen gemäß dem Patentanspruch 1, sowie eine Vorrichtung zur Durchführung dieses Verfahrens gemäß dem Patentanspruch 3.

Zur Beschichtung von Oberflächen mittels vakuum-gestützter Verfahren, wie zum Beispiel die Sputterbeschichtung oder das Beschichten in einem Bedampfungsprozeß mit thermisch aktivierten Beschichtungssubstanzen erfordert üblicherweise die vorherige Reinigung der zu beschichtenden Oberflächen.

Bekannt ist, die Oberflächen mittels Plasmaanwendung, insbesondere mittels einer in der Beschichtungskammer selbst oder in einer separaten Reinigungskammer durchgeführten Glimmentladung durchzuführen. Dabei werden die zu reinigenden Oberflächen nach Einschleusung in die Reinigungskammer einem vor den Oberflächen brennenden Plasma unter Glimmentladungsbedingungen ausgesetzt. Die Einwirkung der aus dem Plasma auf die Oberfläche auftreffenden Teilchen löst die auf der Oberfläche abhaftenden Verunreinigungen ab. Zum Zünden und Aufrechterhalten der Glimmentladung ist neben einem definierten Zündpotential zwischen den Zündelektroden die Einstellung eines Mindestdrucks für das Plasmaprozeßgas notwendig. Dieser Mindestdruck wird üblicherweise durch evakuieren der Vakuumkammer mittels Vakuumpumpen nachteilig erst nach einer Wartezeit erreicht. Weiterhin ist bei der Glimmentladungsreinigung darauf zu achten, daß die Glimmentladung bei einem konstanten Kammerdruck betrieben wird, da die Effektivität der Plasmareinigung stark druckabhängig ist. Um den Kammerdruck stabil zu halten, ist somit eine aufwendige manuelle oder automatisch gesteuerte Druckregelung nachteilig erforderlich.

Um diese Entladebedingungen ohne Beeinträchtigung für die, während des Beschichtungsprozesses gesetzten Prozeßvorrichtungen einhalten zu können, wird die Reinigung in einer separaten Vakuumkammer durchgeführt, in welcher ausschließlich die Glimmentladungsvorrichtungskomponenten angeordnet sind, wodurch der gesamte Reinigungsprozeß die Vakuumbeschichtung zeitaufwendig und wirtschaftlich aufwendig macht.

Das Dokument JP-A-06 232 056 zeigt eine Vakuumkammer, in der zur Beschichtung eines Substrates durch Sputtern eine Kathode angeordnet ist. Zusätzlich weist die Vakuumkammer Barriereentladungslampen auf. Die Barriereentladungen sollen gleichzeitig mit dem Sputtern stattfinden.

Die Reinigung von Substraten durch Barrierentladungsvorrichtungen ist außerdem an sich durch die Dokumente JP-A-0 631 2131 und JP-A-0 631 2130 bekannt geworden.

Aufgabe der Erfindung ist, ein Reinigungsverfahren für unter Vakuumbedingungen zu beschichtende Oberflächen anzugeben, welches die vorgenannten Nachteile vermeidet.

Erfindungsgemäß wird diese Aufgabe durch ein Verfahren gemäß Anspruch 1 bzw. eine Vorrichtung gemäß Anspruch 3 gelöst. Die zur Erzeugung der dielektrisch behinderten Entladung, die auch als Barriereentladung bezeichnet wird, erforderliche Entladevorrichtung besteht im wesentlichen aus mindestens zwei Elektroden, einem in dem Entladungsraum zwischen den Elektroden angeordneten Dielektrikum und eine mit den Elektroden verbundenen Stromquelle. Die prinzipielle Arbeitsweise eine derartigen Barriereentladung ist in dem Stand der Technik im Journal of Applied Spectroscopy Band 41, Nr. 4, Oktober 1984, auf den Seiten 1194 bis 1197 näher erläutert. Bei dem durch die dielektrisch behinderte Entladung induzierten Reinigungsprozeß, werden die auf der Oberfläche anlagernden Verunreinigungen entweder durch einen photochemischen Zersetzungsprozeß mittels der durch die Entladung emittierten auf die Oberfläche auftreffende UV-Strahung bewirkt oder durch die aus dem Entladungsplasma der dielektrischen Entladung direkt auf die Oberfläche auftreffenden Plasmateilchen, die eine plasmachemische Zersetzung bewirken. Abhängig von der Ausbildung der Barriereentladungsvorrichtung ist die simultane Reinigung mittels photochemischer und plasmachemischer Zersetzung möglich.

Von Vorteil ist, daß der Betrieb einer derartigen Barriereentladungsvorrichtung generell in einem Druckbereich bis zu 10 bar möglich ist, wodurch die Anwendung dieses Verfahrens insbesondere auch unter atmosphärischen Druckbedingungen ermöglicht. Der Reinigungsprozeß kann somit unmittelbar nach Einbringen der zu reinigenden Oberfläche in die Vakuumkammer gestartet werden und während der gesamten Abpumpzeit betrieben werden. Damit benötigt der Reinigungsprozeß selbst und damit der gesamte Beschichtungsprozeß weniger Zeit. Der Zeitgewinn beträgt durch Einsparung dieser Wartezeit ca. 25%-30% bezogen auf die gesamte Prozeßzykluszeit für den zu beschichtenden Substratkörpert. Da die Barriereentladung in ihren Druckbedinguungen nur wenig eingeschränkt ist muß für einen Reinigungsproß keine zusätzliche Vakuumkammer bereitgestellt werden, wodurch das Reinigungsverfahren auch besonders wirtschaftlich ist. Die während des Reinigungsprozesses in die Gasphase freigesetzten Verunreinigungen werden beim Abpumpprozeß mit abgepumpt, wodurch eine spätere Wiederbedeckung der gereinigten Oberflächen mit diesen Verunreinigungen während des Beschichtungsprozesses vorteilhaft unterbunden wird.

Auf die derartig gereinigten Oberflächen können, in einem sich anschließenden Beschichtungsprozeß, insbesondere mittels Sputterbeschichten und/oder Bedampfungsbeschichtung z.B. metallische oder kunststoffhaltige Einzelschichten oder Schichtfolgen aufgebracht werden, die bei gereinigter Oberfläche unmittelbar auf dem Substratträger und dadurch mit einer definierten Haftfestigkeit haften.

Neben einer Reinigung unter Verwendung einer dielektrisch behinderten Entladung ist als ein zusätzliches Reinigungsverfahren die Verwendung einer Glimmentladungsvorrichtung vorgesehen (siehe Unteranspruch 4). Die Kombination derartiger Reinigungsverfahren ist vorteilhaft, da z.B. in einem ersten Reinigungsschritt während der Abpumpphase die Barriereentladung betrieben wird und nach erreichen eines Mindestdrucks die Glimmentladung gezündet werden kann.

Da die dielektisch behinderte Entladung die Oberfläche mit keiner oder nur geringer Erwärmung reinigt, eignet diese sich für die Reinigung einer Vielzahl von aus unterschiedlichen Materialien bestehenden Oberflächen, von Vorteil jedoch für thermisch nicht belastbare Oberflächen, wie z.B. Kunststoffoberflächen, insbesondere gefertigt aus Thermoplasten und Polyäthylenen.

Weitere vorteilhafte Weiterbildungen der Erfindung sind in den Unteransprüchen 2 bis 5 angegeben.

Die Verwendung dielektrischer Entladungsvorrichtung sowie ein erfindungsgemäßes Verfahren sind in den in den Figuren 1 bis 3 dargestellten vorteilhaften Ausführungsbeispielen näher erläutert. Es zeigen:
- Fig. 1: einen Schnitt durch eine Vakuumbeschichtungskammer mit integrierter Barriereentladungsvorrichtung,
- Fig. 2: einen Detailausschnitt der Fig. 1 in vergrößerter Darstellung und
- Fig. 3: einen Schnitt durch eine Vakuumbeschichtungskammer nach einem zweiten Ausführungsbeispiel.

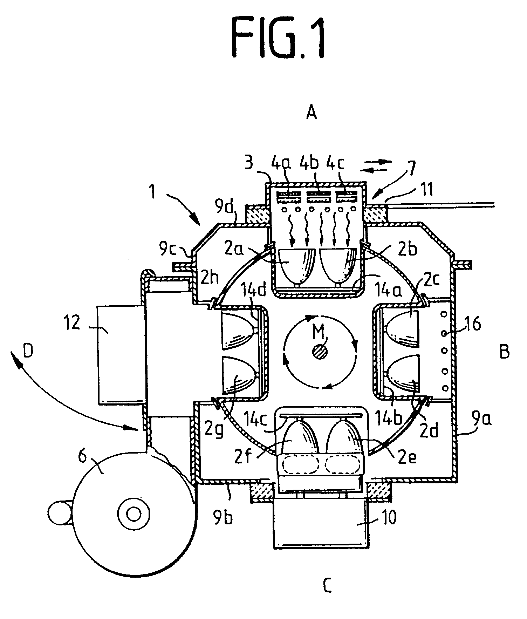

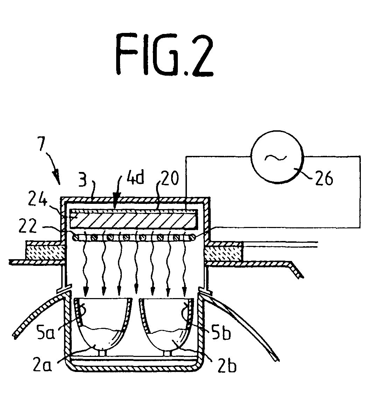

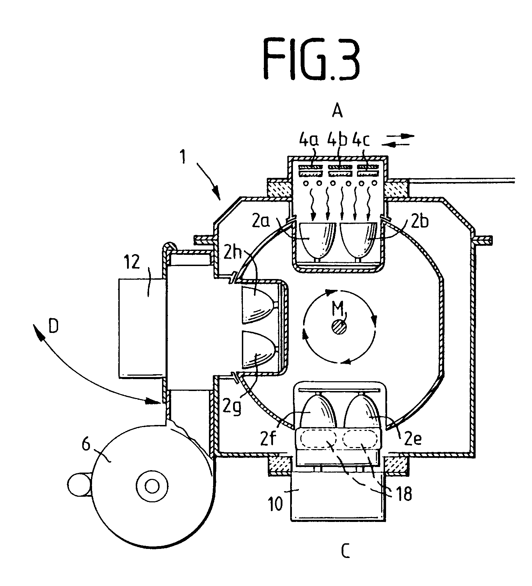

Die in Fig. 1 dargestellte Vakuumbeschichtungskammer besteht im wesentlichen aus einer evakuierbaren Vakuumkammer 1, die einen im wesentlichen rechteckigen Grundquerschnitt aufweist, wobei in die Kammerwände 9a, 9b, 9c, 9d jeweils sich gegenüberliegende Vakuumprozeßstationen A,B,C,D angeordnet sind. Bei den zu beschichtenden Oberflächen der Substratkörper 2a-2h (siehe Fig. 2) handelt es sich um Scheinwerferinnenreflektorflächen 5a, 5b, die jeweils paarweise auf einer Haltevorrichtung 14a, 14b, 14c, 14d in der Vakkumkammer 1 angeordnet sind. Zur Beschickung der Vakuumkammer 1 werden die Substratkörper 2a-2h über die Schleuse 7 in die Vakuumkammer 1 eingebracht. Die Schleuse 7 besteht dabei im wesentlichen aus einer parallel zur Kammerwand 9d in Richtung der eingezeichneten Pfeile verschiebbaren Schleusentür 11. Die Schleusentür 11 weist eine Ausnehmung 3 auf, in welche drei einzelne Barriereentladungsvorrichtungen 4a, 4b, 4c angeordnet sind, die in bekannter und in der Zeichnung nicht näher dargestellter Art ausgebildet ist und im wesentlichen aus mindestens zwei Elektroden, sowie einem in den Entladungsraum zwischen und benachbart zu einer Elektrode angeordneten Dielktrikum besteht und einer ebenfalls nicht dargestellten Stromquelle besteht. Bei geschlossener Schleusentür 11 sind die Barriereentladungsvorrichtungen 4a - 4c gegenüber den zu reinigenden Oberflächen 5a, 5b positioniert und mit den, die UV-Strahlung emittierenden Plasmavolumen diesen zugewandt. Die gesamte Vakuumkammer 1 wird nach dem Schließen der Schleuse 7 mittels Vakuumpumpen 6 evakuiert. Während der gesamten Abpumpphase auf den zur Beschichtung notwendigen Kammerdruck, werden die Barriereentladungsstrahler 4a - 4c aktiviert, wobei die aus den Strahlern 4a - 4c austretende UV-Strahlung auf die zu reinigenden Oberflächen 5a, 5b auftritt und diese mittels photochemischer Zersetzung reinigt. Nach erreichen des für die folgenden Beschichtungsprozesse notwendigen Enddrucks innerhalb einer typischen Evakuierungszeit von ca. 15 Sek., werden die um den Kammermittelpunkt M auf einem Drehkarussell 13 gelagerten Substratkörper 2a - 2h zu einer zweiten Prozeßstation B gedreht. In der Station B können die vorgereinigten Oberflächen 5a, 5b z.B. mittels einer Glimmentladevorrichtung 16 einem zweiten Reinigungsprozeß unterzogen werden. Kann auf diesen zweiten Reinigungsprozeß in der Station B verzichtet werden, so kann wie in Fig. 3 dargestellt die Beschichtungsstation B ganz entfallen. Die in der Station A und/oder B gereinigten Substratkörperoberflächen 5a, 5b, werden nach Weitertransport mittels des Drehkarussells 13 vor die Prozeßstation C bzw. D in einem vakuumgestützten Beschichtungsverfahren z. B. mit einer reflektierenden Metallschicht und einer auf die Metallschicht mittels einer Schutzschichtbeschichtungsvorrichtung 12 aufgebrachten transparenten Schutzschicht beschichtet. Zur Entnahme der beschichtenden Substratkörper 2a -2h werden diese in die Entnahme- bzw. Beschickungsstation A wie durch die Drehrichtungspfeile angedeutet weitergedreht und nach Öffnen der Schleusentür 11 aus der Vakuumkammer 1 entnommen.

Ein weitere Ausbildung der Barriereentladevorrichtung ist in Fig. 2 dargestellt. Bei diesem Ausführungsbeispiel ist die erste Elektrode 20 plattenförmig ausgebildet und ist an ihrer den Substratkörperoberflächen 5a, 5b zugewandten Fläche mit einer aus einer dielektrischen Substanz bestehenden Platte 24 bedeckt. Die zweite Elektrode 22 besteht aus einer Gitteranordnung, die sowohl für die aus dem zwischen dem Dielektrikum und der zweiten Elektrode Entladungsraum (Entladungsstrecke) austretende UV-Strahlung wie auch für Plasmateilchen teilweise transparent ist. Diese Elektrodenausbildung hat den Vorteil, daß die Strahlungsquelle (UV-,Plasmateilchenquelle) über den gesamten zu reinigenden Flächenbereich homogen abstrahlt, wodurch die Oberflächen gleichmäßig gereinigt werden. Zur elektrischen Versorgung der Elektrode 20 bzw. 22 ist eine mit den Elektroden elektrisch leitend verbundene Stromquelle 26 vorgesehen.

### Bezugszeichenliste

- 1: Vakuumkammer
- 2: Substratkörper
- 3: Ausnehmung
- 4: a, b, c, d, Strahlungsquelle
- 5: a, b) Oberflächen
- 6: Pumpvorrichtung
- 7: Schleuse
- 8: Transportvorrichtung
- 9: Kammerwand / a, b, c, d
- 10: Sputtervorrichtung
- 11: Schleusentür
- 12: Schutzschichtsputtervorrichtung
- 13: Drehkarussell
- 14: a, b, d, d = Haltevorrichtung
- 16: Glimmentladevorrichtung
- 18: Plasmazone
- 20: Erstelektrode
- 22: Zweitelektrode
- 24: Dielektrikum
- 26: Stromquelle

- A: Reinigungsstation
- B: Glimmreinigungsstation
- C: Sputterbeschichtungsstation
- D: Schutzbeschichtungsstation

- M: Drehpunkt

## Patentansprüche

1. Verfahren zur Behandlung eines Substrates innerhalb einer Vakuumkammer durch eine Barriereentladungsvorrichtung und zusätzlich durch ein Vakuumbeschichtungsverfahren, **dadurch gekennzeichnet, dass** die Behandlung durch die Barriereentladungsvorrichtung während der für das Vakuumbeschichtungsverfahren erforderlichen Evakuierungsphase und damit zeitlich vor dem Vakuumbeschichtungsverfahren erfolgt.

2. Verfahren nach Anspruch 1, **dadurch gekennzeichnet, dass** zusätzlich zur Behandlung durch die Barriereentladungsvorrichtung in der Vakuumkammer vor der Vakuumbeschichtung eine Reinigung durch eine Glimmentladungsvorrichtung erfolgt.

3. Vorrichtung zum Beschichten von Substratkörpern (2) gemäß dem Verfahren nach den Ansprüchen 1 oder 2, welche eine Vakuumkammer (1) hat, in der eine Barrieereentladungsvorrichtung (4) und zusätzlich eine Sputtervorrichtung (10) angeordnet ist, **dadurch gekennzeichnet, dass** die Barriereentladungsvorrichtung (4) und die Sputtervorrichtung (10) separate Prozessstationen (A, B) bilden und zum Transport der Substratkörper (2) innerhalb der Vakuumkammer (1) von einer Prozessstation (A, B) zur anderen ein Drehkarussell (13) vorgesehen ist.

4. Vorrichtung nach Anspruch 3, **dadurch gekennzeichnet, dass** in der Vakuumkammer (1) zusätzlich zu der Barriereentladungsvorrichtung (4) eine Substratreinigungsstation (B) mit einer Glimmentladungsvorrichtung (16) vorgesehen ist.

5. Vorrichtung nach den Ansprüchen 3 oder 4, **dadurch gekennzeichnet, dass** die Barriereentladungsvorrichtung (4) in einer Ausnehmung einer Schleusentür (11) einer Schleuse (7) der Vakuumkammer (1) angeordnet ist.

## Claims

1. A process for treating a substrate inside a vacuum chamber using a barrier discharge device and additionally using a vacuum coating process, **characterised in that** treatment with the barrier discharge device proceeds during the evacuation phase necessary for the vacuum coating process and thus timewise before the vacuum coating process.

2. A process according to claim 1, **characterised in that**, in addition to treatment using the barrier discharge device, cleaning using a glow discharge device is performed in the vacuum chamber prior to vacuum coating.

3. A device for coating substrate elements (2) by the process according to claims 1 or 2, which has a vacuum chamber (1), in which there are arranged a barrier discharge device (4) and also a sputtering device (10), **characterised in that** the barrier discharge device (4) and the sputtering device (10) constitute separate process stations (A, B) and a rotary carousel (13) is provided for conveying the substrate elements (2) inside the vacuum chamber (1) from one process station (A, B) to the other.

4. A device according to claim 3, **characterised in that** a substrate cleaning station (B) with a glow discharge device (16) is provided in the vacuum chamber (1) in addition to the barrier discharge device (4).

5. A device according to claims 3 or 4, **characterised in that** the barrier discharge device (4) is arranged in a recess in an air lock door (11) of an air lock (7) of the vacuum chamber (1).

## Revendications

1. Procédé pour traiter un substrat à l'intérieur d'une enceinte à vide au moyen d'un dispositif de décharge à barrière et en outre au moyen d'un procédé de dépôt sous vide, **caractérisé en ce que** le traitement est réalisé au moyen du dispositif de décharge à barrière pendant la phase de création de vide, qui est nécessaire pour le procédé de dépôt sous vide, et par conséquent à un instant se situant avant le procédé de dépôt sous vide.

2. Procédé selon la revendication 1, **caractérisé en ce qu'**en plus du traitement effectué par le dispositif de décharge à barrière dans la chambre à vide, un nettoyage est exécuté avant le dépôt sous vide, au moyen d'un dispositif de décharge à effluves.

3. Dispositif pour appliquer un revêtement sur des corps formant substrats (2) conformément au procédé selon la revendication 1 ou 2, qui comporte une chambre à vide (1), dans laquelle sont disposés un dispositif de décharge à barrière (4) et en outre un dispositif de pulvérisation (10), **caractérisé en ce que** le dispositif de décharge à barrière (4) et le dispositif à pulvérisation (10) forment des postes de traitement séparés (A, B) et qu'il est prévu un carrousel rotatif (13) pour le transport des corps formant substrats (2) à l'intérieur de la chambre à vide (1), d'un poste de traitement (A, B) à l'autre.

4. Dispositif selon la revendication 3, **caractérisé en ce qu'**un poste (B) de nettoyage des substrats équipé d'un dispositif de décharge à effluves (16) est prévu dans la chambre à vide (1) en plus du dispositif de décharge à barrière (4).

5. Dispositif selon la revendication 3 ou 4, **caractérisé en ce que** le dispositif de décharge à barrière (4) est disposé dans un évidement d'une porte (11) d'un sas (7) de la chambre à vide (1).
